# EUROPEAN PATENT SPECIFICATION

(11) **EP 2 371 533 B1**
(45) Date of publication and mention of the grant of the patent: **07.11.2018**
(21) Application number: 09834851.9
(22) Date of filing: 22.12.2009
(51) Int. Cl.: B32B 9/00, B32B 15/08, G02B 1/10, G02B 5/26, G02B 5/28, G09F 9/00, H05K 9/00

(54) **TRANSPARENT LAMINATED FILM AND METHOD FOR PRODUCING THE SAME**
TRANSPARENTER LAMINIERTER FILM UND HERSTELLUNGSVERFAHREN DAFÜR
FILM STRATIFIÉ TRANSPARENT ET PROCÉDÉ DE PRODUCTION ASSOCIÉ

(30) Priority: 25.12.2008 JP 2008328883
(43) Date of publication of application: 05.10.2011
(73) Proprietor: Sumitomo Riko Company Limited, Komaki, Aichi (JP)
(72) Inventor: TAKEUCHI, Tetsuya, Komaki-shi Aichi 485-8550 (JP); TOKUNAGA, Yoshihiro, Komaki-shi Aichi 485-8550 (JP); NARASAKI, Tetsuji, Komaki-shi Aichi 485-8550 (JP); INAGAKI, Hiroki, Komaki-shi Aichi 485-8550 (JP); INUZUKA, Masataka, Komaki-shi Aichi 485-8550 (JP)
(74) Representative: Müller-Boré & Partner Patentanwälte PartG mbB
(86) International application number: PCT/JP2009/071273
(87) International publication number: WO 2010/074050

(56) References cited:
- JP-A- 55 074 864
- JP-A- 63 267 540
- JP-A- 2006 327 177
- JP-A- 2006 327 177
- JP-A- 2007 331 296
- JP-A- 2008 105 251
- JP-A- 2008 293 129
- US-A- 4 413 877
- US-A- 5 270 517
- US-A1- 2003 049 464
- US-A1- 2008 049 308

## Description

The present invention relates to a transparent laminated film and a method for producing the same.

In recent years, optical functional films have been used for heat ray cutting, transparent electrodes and an electromagnetic wave shield of a display device, and the like. As an optical functional film of this kind, conventionally, a transparent laminated film of a so-called multilayer film type is known in which a plurality of various types of thin films are laminated on a transparent polymer film.

For example, in patent document 1, a transparent laminated film is disclosed having a thin film layer in which a TiO₂ thin film | a titanium oxide thin film / an Ag-Bi alloy thin film / a titanium oxide thin film | a TiO₂ thin film | a titanium oxide thin film / an Ag-Bi alloy thin film / a titanium oxide thin film | a TiO₂ thin film | a titanium oxide thin film / an Ag-Bi alloy thin film / a titanium oxide thin film | a TiO₂ thin film are laminated on a polyethylene terephthalate film. Further, in the same document, it is described that the TiO₂ thin films are formed by a sol-gel method using ultraviolet irradiation; the titanium oxide films are formed by reactive sputtering; and the Ag-Bi alloy thin films are formed by sputtering.
Patent document 1: Japanese Patent Laid-Open Publication No. 2008-105251
Patent document 2: US-patent 4,413,877 describes a selectively light-transmitting laminated structure.

However, the conventional transparent laminated film had room for improvement on the following point.

That is, it has become clear that, when the conventional transparent laminated film is exposed to sunlight for a long period of time during use or is irradiated by ultraviolet light during quality evaluation, peeling of the thin film layer may occur. This problem tends to occur markedly at an interface between the transparent polymer film, which is a base material, and the thin film layer.

The present invention is devised in consideration of the above described problem. A problem that the present invention intends to solve is to provide a transparent laminated film capable of inhibiting peeling of a thin film layer even when the transparent laminated film is exposed to sunlight for a long period of time during use or is irradiated by ultraviolet light during quality evaluation.

To solve the above problem, a transparent laminated film according to the present invention has a thin film layer in which a plurality of thin films are laminated on at least one surface of a transparent polymer film. The thin film layer contains a metal oxide thin film formed by a sol-gel method using light energy during sol-gel hardening, and a post-oxidation thin film formed by post-oxidizing a silver alloy thin film and at least one kind of thin film selected from a metal Ti thin film and a partially oxidized titanium oxide thin film,
wherein the post-oxidation thin film formed by post-oxidizing at least one of the metal Ti thin film and the partially oxidized titanium oxide thin film exists adjacent to the post-oxidation thin film formed by post-oxidizing the silver alloy thin film.

Further, it is desirable that the thin film layer contain a metal oxide thin film formed by a sol-gel method using light energy during sol-gel hardening and arranged in contact with the transparent polymer film.

Further, it is desirable that, when the post-oxidation thin film contains at least one of a thin film formed by post-oxidizing the metal Ti thin film and a thin film formed by post-oxidizing the partially oxidized titanium oxide thin film, the post-oxidation thin film have a film thickness within a range of 2 - 6 nm.

Further, it is desirable that the silver alloy contain, as secondary alloy elements, one kind or two or more kinds of elements selected from Cu, Cr, Fe, Ni, Pb, Si, Ti, V, Y, and Zr.

In particular, it is desirable that the silver alloy be an Ag-Cu alloy or an Ag-Ti alloy.

The above described transparent laminated film can be suitably used for heat ray cutting.

Further, it is desirable that the post-oxidation thin film is laminated between the metal oxide thin film formed by a sol-gel method and the metal oxide thin film formed by a sol-gel method.

A transparent laminated film production method according to the present invention includes a lamination process forming, on at least one surface of a transparent polymer film, a thin film layer containing a metal oxide thin film formed by a sol-gel method using light energy during sol-gel hardening, a silver alloy thin film and at least one kind of thin film selected from a metal Ti thin film and a partially oxidized titanium oxide thin film; and a post-oxidation process forming a post-oxidation thin film by post-oxidizing the silver alloy thin film and the at least one kind of thin film selected from a metal Ti thin film and a partially oxidized titanium oxide thin film, the post-oxidation thin film being contained in the thin film layer.

Here, it is desirable that the post-oxidation process be performed by post-oxidizing the transparent polymer film having the thin film layer.

Further, it is desirable that the transparent polymer film having the thin film layer be wound in a roll-like form.

Further, the post-oxidation can be performed by post-processing such as a heat treatment or a chemical treatment and the like, or by natural oxidation and the like. Preferably, it is desirable that the post-oxidation be via a heat treatment.

In this case, it is desirable that a heating temperature during the heat treatment be equal to or below a softening temperature of a material constituting the transparent polymer film having the thin film layer.

The transparent laminated film according to the present invention contains, in the thin film layer, a metal oxide thin film formed by a sol-gel method using light energy during sol-gel hardening, and a post-oxidation thin film formed by post-oxidizing a silver alloy thin film and at least one kind of thin film selected from a metal Ti thin film and a partially oxidized titanium oxide thin film.

Therefore, even when exposed to sunlight for a long period of time during use or is irradiated by ultraviolet light during quality evaluation, peeling of the thin film layer can be inhibited. This is conjectured to be due to the following mechanism.

That is, in the case of the conventional transparent laminated film, when struck by sunlight (ultraviolet light), a starting material (such as a metal alkoxide) from a sol-gel method remaining in a metal oxide thin film reacts with moisture (such as adsorbed water), oxygen, and the like, causing hardening contraction to progress and internal stress to occur. Due to this internal stress, peeling occurs at the interface between the transparent polymer film and the thin film layer.

However, when a post-oxidation thin film is contained in the thin film layer, during post-oxidation, volume expansion occurs due to oxidation of the metal, alloy, and partially oxidized metal oxide, which relieves the internal stress occurring due to sol-gel hardening contraction. Further, during post-oxidation, adsorbed water or oxygen that is contained in a metal oxide thin film formed by a sol-gel method is consumed, so that, even when exposed to sunlight (ultraviolet light), sol-gel hardening is less likely to occur. Thus, it is believed that, even when the transparent laminated film according to the present invention is exposed to sunlight during use or irradiated by ultraviolet light during quality evaluation, peeling of the thin film layer is less likely to occur.

Here, as conventionally known, when a metal oxide thin film formed by a sol-gel method using light energy during sol-gel hardening is laminated on a surface of a transparent polymer film, peeling of the thin film layer was particularly likely to occur due to a large difference in material quality and reasons of the preparation method such as a coating method.

However, according to the present invention, even when the thin film layer contains a metal oxide thin film arranged in contact with the transparent polymer film, the above described peeling of the thin film layer can be inhibited.

Further, when the post-oxidation thin film contains a thin film formed by post-oxidizing at least one of a metal Ti thin film and a partially oxidized titanium oxide thin film, which exist adjacent to an alloy thin film, the effect due to post-oxidation becomes large. Therefore, the peeling inhibition effect of the thin film layer becomes large.

Further, in the case where the post-oxidation thin film contains at least one of a thin film formed by post-oxidizing the metal Ti thin film and a thin film formed by post-oxidizing the partially oxidized titanium oxide thin film, when the post-oxidation thin film has a thickness within a range of 2 - 6 nm, peeling within the thin film layer, particularly peeling at the part of the thin film formed by post-oxidizing at least one of a thin film formed by post-oxidizing a metal Ti thin film and a thin film formed by post-oxidizing a partially oxidized titanium oxide thin film, becomes easily inhibited. This is believed to be due to higher film strength as compared to the conventional case.

Further, since the metal thin film is a metal Ti thin film, the alloy thin film is a silver alloy thin film, and the partially oxidized metal oxide thin film is a partially oxidized titanium oxide thin film, visible light transparency, heat ray reflectivity, durability, and the like, are superior.

Further, when the silver alloy contains, as secondary alloy elements, one kind or two or more kinds of elements selected from Cu, Cr, Fe, Ni, Pb, Si, Ti, V, Y and Zr, post-oxidation becomes easy. Therefore, a peeling inhibition effect of the thin film layer is superior. In particular, when the silver alloy is an Ag-Cu alloy or an Ag-Ti alloy, the peeling inhibition effect of the thin film layer is large.

Further, when the transparent laminated film according to the present invention is used for heat ray cutting, there are relatively more chances of being exposed to sunlight. However, even in this case, high reliability over a long period of time can be ensured.

The transparent laminated film production method according to the present invention includes the above described lamination process and post-oxidation process. Therefore, the metal Ti thin films, silver alloy thin films, and the like that are contained in the thin film layer formed via the lamination process can be post-oxidized via the following post-oxidation process. Thus, the above described transparent laminated film, capable of inhibiting peeling of the thin film layer even when exposed to sunlight for a long period of time during use or irradiated by ultraviolet light during quality evaluation, can be obtained.

Here, when the post-oxidation process is performed by post-oxidizing the transparent polymer film having the thin film layer, each of the thin films to be post-oxidized contained in the thin film layer can be relatively simply post-oxidized and at one time. Therefore, film productivity is superior.

Further, when the transparent polymer film having the thin film layer is wound in a roll-like form, roll bodies can be post-oxidized in batch. Therefore, there are advantages such as that it is easy to achieve production equipment simplification, unmanned operation, and the like.

Further, when the post-oxidation is performed via a heat treatment, the post-oxidation can be performed relatively simply and reliably.

In this case, when a heating temperature during the heat treatment is equal to or below a softening temperature of a constituent material constituting the transparent polymer film having the thin film layer, thermal deformation due to heating can be prevented. Further, when the transparent laminated film is wound in a roll-like form, inter-film thermal fusion bonding and the like can be inhibited.

A transparent laminated film according to an embodiment of the present invention (may be referred to as "the present film" in the following) and a production method thereof (may be referred to as "the present production method" in the following) are explained in detail.

### 1. The present film

The present film has a transparent polymer film and a thin film layer. The thin film layer may be formed on any one surface of the transparent polymer film or may be laminated on both surfaces of the transparent polymer film.

In the present film, the transparent polymer film acts as a base material for forming the thin film layer. As a material of the transparent polymer film, anything can be used that is transparent in the visible light range and allows a thin film to be formed on a surface thereof without any difficulty.

Examples of the material of the transparent polymer film include, specifically, for example, polymer materials such as a polyethylene terephthalate, a polycarbonate, a polymethylmethacrylate, a polyethylene, a polypropylene, an ethylene-vinyl acetate copolymer, a polystyrene, a polyimide, a polyamide, a polybutylene terephthalate, a polyethylene naphthalate, a polysulfone, a polyether sulfone, a polyether ether ketone, a polyvinyl alcohol, a polyvinyl chloride, a polyvinylidene chloride, a triacetyl cellulose, a polyurethane, and a cycloolefin polymer. One kind or two or more kinds of these materials may be contained. Further, two or more kinds of transparent polymers may be laminated and used.

Among these materials, a polyethylene terephthalate, a polycarbonate, a polymethylmethacrylate, a cycloolefin polymer, and the like are examples of suitable materials particularly from the point of view of having superior transparency, durability, workability and the like.

The transparent polymer film may have a surface-treatment layer such as an easy-adhesion layer formed on one surface or both surfaces thereof. In addition, when a transparent polymer film having an easy-adhesion layer formed on one surface thereof is used, it is preferred that the thin film layer be formed on a film surface where the easy-adhesion layer is not formed. This is because there are advantages such as having a large cracking inhibition effect during a metal oxide thin film formation using a sol-gel method.

Thickness of the transparent polymer film can adjusted in various ways in consideration of an intended purpose of the present film, the material of the film, optical characteristics, durability, and the like. It is desirable that the thickness of the transparent polymer film have a lower limit of preferably 25 µm or more, and more preferably 50 µm or more, from the point of view of being less likely to get wrinkles, being less likely to break, and the like during processing. On the other hand, it is desirable that the thickness of the transparent polymer film have an upper limit of preferably 500 µm or less, and more preferably 250 µm or less, from the point of view of making it easy to be wound, economic efficiency, and the like.

In the present film, the thin film layer is formed by laminating a plurality of thin films and contains at least a metal oxide thin film and a post-oxidation thin film. The thin film layer may contain one or two or more metal oxide thin films and post-oxidation thin films having identical or different chemical composition and film thickness.

Examples of a basic laminated structure of the thin film layer include a laminated structure and the like having metal oxide thin films and post-oxidation thin films alternately laminated. Further, among the thin films constituting the thin film layer, it is desirable that a thin film arranged in contact with the transparent polymer film be a metal oxide thin film. This is because there are advantages such as superior optical characteristics including high visible light transmission, low visible light reflection, and the like.

Examples of a specific laminated structure of the thin film layer include, for example, from the transparent polymer film side, a metal oxide thin film | a post-oxidation thin film | a metal oxide thin film (3 layers), a metal oxide thin film | a post-oxidation thin film | a metal oxide thin film | a post-oxidation thin film | a metal oxide thin film (5 layers), a metal oxide thin film | a post-oxidation thin film | a metal oxide thin film | a post-oxidation thin film | a metal oxide thin film | a post-oxidation thin film | a metal oxide thin film (7 layers), a metal oxide thin film | a post-oxidation thin film | a metal oxide thin film | a post-oxidation thin film | a metal oxide thin film | a post-oxidation thin film | a metal oxide thin film | a post-oxidation thin film | a metal oxide thin film (9 layers), a post-oxidation thin film | a metal oxide thin film (2 layers), a post-oxidation thin film | a metal oxide thin film | a post-oxidation thin film | a metal oxide thin film (4 layers), a post-oxidation thin film | a metal oxide thin film | a post-oxidation thin film | a metal oxide thin film | a post-oxidation thin film | a metal oxide thin film (6 layers), a post-oxidation thin film | a metal oxide thin film | a post-oxidation thin film | a metal oxide thin film | a post-oxidation thin film | a metal oxide thin film | a post-oxidation thin film | a metal oxide thin film (8 layers), a post-oxidation thin film | a metal oxide thin film | a post-oxidation thin film | a metal oxide thin film | a post-oxidation thin film | a metal oxide thin film | a post-oxidation thin film | a metal oxide thin film | a post-oxidation thin film | a metal oxide thin film (10 layers), and the like.

As a laminated structure of the thin film layer, an odd number of layers such as 3 layers, 5 layers, 7 layers, 9 layers and the like are preferred from the point of view of optical characteristics, durability, and the like, and 3 layers, 5 layers and 7 layers are particularly preferred from the point of view of a balance between economic efficiency and performance. In addition, as will be described later, a post-oxidation thin film may be constituted by a plurality of thin films. However, in this case, the thin films constituting the post-oxidation thin film are collectively counted as one layer.

Here, in the present film, a metal oxide thin film is transparent in the visible light range and can perform primarily as a film having a high refractive index. In addition, high refractive index refers to a case where a refractive index with respect to 633-nm light is 1.7 or more.

The metal oxide thin film is formed by a sol-gel method using light energy during sol-gel hardening. The sol-gel method allows a metal oxide thin film to be formed by a relatively inexpensive wet process, while inhibiting thermal deformation of the transparent polymer film. Further, an organic component (such as a metal alkoxide) originating from a starting material can remain in a metal oxide thin film. This improves flexibility of the thin film and contributes to cracking inhibition.

However, when trying to enjoy such advantages, hardening contraction of a thin film by a sol-gel method progresses due to exposure to sunlight (ultraviolet light), and peeling of the thin film layer becomes likely to occur. Therefore, in the present invention, the metal oxide thin film is used in combination with a post-oxidation thin film.

Examples of a metal oxide, by which a metal oxide thin film is primarily constituted, include, specifically, for example, a titanium oxide, a zinc oxide, an indium oxide, a tin oxide, an indium tin oxide, a magnesium oxide, an aluminum oxide, a zirconium oxide, a niobium oxide, a cerium oxide, and the like. One kind or two or more kinds of these metal oxides may be contained. Further, these metal oxides may be multiple oxides combining two or more kinds of metal oxides.

As the metal oxide, a titanium oxide (TiO₂), an ITO, a zinc oxide (ZnO), a tin oxide (SnO₂), and the like are examples of a preferred metal oxide particularly from the point of view, for example, of having a relatively high refractive index with respect to visible light. One kind or two or more kinds of these oxides may be contained.

In addition to the metal oxide, a metal oxide thin film may contain an organic component and the like originating from a starting material of the sol-gel method as described above.

Examples of the organic component include, more specifically, for example, organic metallic compounds (including decomposed materials thereof) such as a metal alkoxide, a metal acylate and a metal chelate or the like of a metal constituting the metal oxide described above, various types of additives such as organic compounds (to be described later) reacting with the organic metallic compounds to form light-absorbing (ultraviolet light-absorbing and the like) chelates, and the like. One kind or two or more kinds of these materials may be contained.

It is desirable that content of an organic component contained in a metal oxide thin film have a lower limit of preferably 3% by mass or more, more preferably 5% by mass or more, and even more preferably 10% by mass or more, from the point of view of making it easy to provide flexibility and the like. On the other hand, it is desirable that the content of the organic component contained in the metal oxide thin film have an upper limit of preferably 30% by mass or less, more preferably 25% by mass or less, and even more preferably 20% by mass or less, from the point of view of making it easy to ensure a high refractive index and the like.

In addition, the content of the organic component can be investigated by using X-ray photoelectron spectroscopy (XPS) and the like. Further, the type of the organic component can be investigated by using infrared spectroscopy (IR) (infrared absorption analysis) and the like.

Film thickness of the metal oxide thin film can be adjusted in various ways in consideration of low reflectivity, high transparency, heat ray cuttability, color and the like of the transparent laminated film in the visible light range. It is desirable that the film thickness of the metal oxide thin film have a lower limit of preferably 16 nm or more, more preferably 18 nm or more, and even more preferably 20 nm or more, from the point of view of, for example, making it easy to achieve low reflectivity, high transparency and achromatization. On the other hand, it is desirable that the film thickness of the metal oxide thin film have an upper limit of preferably 150 nm or less, more preferably 120 nm or less, and even more preferably 90 nm or less, from the point of view of heat ray cuttability, cracking inhibition, and the like.

A metal oxide thin film having a configuration as described above can be formed as follows. Specifically, for example, a coating liquid is prepared containing an organic metallic compound containing a metal that constitutes a metal oxide, various types of additives that are added as needed, and the like. The prepared coating liquid is coated in a thin film shape, which is dried as needed to form a precursor film of a metal oxide thin film. Thereafter, the precursor film is irradiated with light energy of ultraviolet light and the like to cause the organic metallic compound in the precursor film to undergo hydrolysis and condensation reaction to synthesize an oxide of the metal constituting the organic metallic compound. This allows a metal oxide thin film to be formed using a light energy irradiation method and a sol-gel method.

The coating liquid can be prepared by dissolving or dispersing the organic metallic compound and the like in an adequate solvent. Examples of the organic metallic compound include, specifically, for example, organic compounds of metals such as titanium, zinc, indium, tin, magnesium, aluminum, zirconium, niobium, cerium, silicon, hafnium and lead. One kind or two or more kinds of these may be contained.

Examples of the organic metallic compound include, specifically, for example, metal alkoxides, metal acylates, metal chelates and the like of the above mentioned metals. It is desirable that the organic metallic compound preferably be a metal chelate, from the point of view of stability in the air.

As the organic metallic compound in particular, an organic compound of a metal that can lead to a metal oxide having a high refractive index can be preferably used. Examples of such an organic metallic compound include, for example, an organic titanium compound and the like.

Examples of the organic titanium compound include, specifically, for example, titanium alkoxides having a M-O-R bond (where R denotes an alkyl group and M denotes a titanium atom) such as tetra-n-butoxy titanium, tetraethoxy titanium, tetra-i-propoxy titanium and tetramethoxy titanium; titanium acylates having a M-O-CO-R bond (where R denotes an alkyl group and M denotes a titanium atom) such as isopropoxy titanium stearate; and titanium chelates such as diisopropoxy titanium bis acetylacetonato, dihydroxy bis lactato titanium, diisopropoxy bis triethanol aminato titanium and diisopropoxy bis ethyl acetoacetate titanium. One kind or two or more kinds of these may be mixed. Further, these may be monomers or polymers.

It is desirable that content of an organic metallic compound in the coating liquid is within a range of preferably 1 - 20% by mass, more preferably 3 - 15% by mass, and even more preferably 5 - 10% by mass, from the point of view of film thickness uniformity of a coated film, film thickness achievable by one coating, and the like.

Examples of favorable additives that can be added to the coating liquid include, for example, organic compounds and the like that react with the organic metallic compound to form light-absorbing (for example, ultraviolet light-absorbing) chelates. This is because when this kind of an additive is added, light energy is irradiated on a place where a light-absorbing chelate was formed in advance. Therefore, a high refractive index can be easily achieved in a metal oxide thin film at a relatively low temperature.

Examples of the additives include, specifically, for example, β diketones, alkoxyalcohols, alkanolamines, and the like. Examples of the β diketones include, for example, acetylacetone, benzoylacetone, ethyl acetoacetate, methyl acetoacetate, diethyl malonate, and the like. Examples of the alkoxyalcohols include, for example, 2-methoxyethanol, 2-ethoxyethanol, 2-methoxy-2-propanol, and the like. Examples of the alkanolamines include, for example, monoethanolamine, diethanolamine, triethanolamine, and the like. One kind or two or more kinds of these may be contained.

Among these, the β diketones are particularly preferable. Among the β diketones, the acetylacetone can be most preferably used.

Further, it is desirable that a mixing ratio of the additives be within a range of preferably 0.1 - 2 moles, and more preferably 0.5 - 1.5 moles, with respect to 1 mole of metal atoms in the organic metallic compound, from the point of view of likelihood to increase a refractive index, cracking inhibition, stability in a coated film state, and the like.

Examples of a solvent that can be suitably used in the preparation of the coating liquid include, specifically, for example, alcohols such as methanol, ethanol, propanol, butanol, heptanol and isopropyl alcohol; organic acid esters such as ethyl acetate; ketones such as acetonitrile, acetone and methyl ethyl ketone; cycloethers such as tetrahydrofuran and dioxane; acid amides such as formamide and N,N-dimethylformamide; hydrocarbons such as hexane; and aromatic series such as toluene. One kind or two or more kinds of these may be mixed.

In this case, it is desirable that an amount of the solvent be within a range of preferably 5 - 100 times, more preferably 7 - 30 times, and even more preferably 10 - 20 times of a weight of a solid component of the organic metallic compound, from the point of view of film thickness uniformity of a coated film, film thickness achievable by one coating, sol-gel polymerization reactivity, and the like.

When the amount of the solvent is more than 100 times, the film thickness that can be formed in one coating becomes thinner, and, in order to achieve a desired film thickness, there is a tendency that multiple coatings become necessary. On the other hand, when the amount of the solvent is less than 5 times, there is a tendency that the film thickness becomes too thick and hydrolysis and condensation reaction of the organic metallic compound are unlikely to progress sufficiently. Therefore, it is desirable that the amount of the solvent be selected by taking these into consideration.

The coating liquid can be prepared, for example, by a method such as stirring and mixing the organic metallic compound weighed to a predetermined percentage, an appropriate amount of the solvent, and additives added as needed, for a predetermined period of time by using a stirrer such as a stirring machine. In this case, the mixing of each component may be done at one time or may be divided into multiple times.

Examples of a preferred coating method of the coating liquid include various wet coating methods such as a micro gravure method, a gravure method, a reverse roll coating method, a dye coating method, a knife coating method, a dip coating method, a spin coating method and a bar coating method, from the point of view of making it easy to perform a uniform coating. These methods can be selected and used as appropriate. One kind or two or more kinds of these methods may be combined.

When drying a coated coating liquid, conventional drying equipment and the like may be used. In this case, examples of drying conditions include, specifically, for example, a temperature range of 80 - 120°C, a drying time of 0.5 - 5 minutes, and the like.

Examples of the light energy for causing the organic metallic compound in the precursor film to undergo hydrolysis and condensation reaction include, specifically, for example, ultraviolet light, an electron beam, X-ray, and the like. One kind or two or more kinds of these may be combined and used. Among these optical energies, the ultraviolet light can be particularly preferably used. This is because a metal oxide can be generated using relatively simple equipment at a low temperature and in a short time, and it is also likely that an organic component will remain.

In this case, examples of ultraviolet irradiation equipment to be used include, specifically, for example, a mercury lamp, a xenon lamp, a deuterium lamp, an excimer lamp, a metal halide lamp, and the like. One kind or two or more kinds of these may be combined and used.

Further, an amount of ultraviolet irradiation can be adjusted in various ways in consideration of the type of the organic metallic compound from which the precursor film is primarily formed, the thickness of the coating layer, and the like. However, when the amount of the ultraviolet irradiation is too small, a high refractive index of the metal oxide thin film is difficult to achieve. On the other hand, when the amount of the ultraviolet irradiation is too large, the transparent polymer film may deform due to heat generated during the ultraviolet irradiation. Therefore, it is preferred to keep these factors in consideration.

It is desirable that, when a measurement wavelength is 300 - 390 nm, the amount of the ultraviolet irradiation be within a range of preferably 300 - 8000 mJ/cm², and more preferably 500 - 5000 mJ/cm², from the point of view of the refractive index of the metal oxide thin film, damage received by the transparent polymer film, and the like.

In the present film, a post-oxidation thin film is a thin film formed by post-oxidizing a silver alloy thin film and at least one kind of thin film selected from a metal Ti thin film and a partially oxidized titanium oxide thin film.

That is, the post-oxidation thin film is a thin film obtained by first forming a thin film as a silver alloy thin film and at least one kind of thin film selected from a metal thin film and a partially oxidized metal oxide thin film, and then post-oxidizing the formed thin film. As compared to a thin film formed by oxidizing from the beginning, the post-oxidation thin film tends to have a precise film quality. A partially oxidized metal oxide thin film is a metal oxide thin film having room for further oxidation.

Examples of a preferred post-oxidation thin film include, for example, a thin film formed by post-oxidizing a metal Ti thin film adjacent to a silver alloy thin film, a thin film formed by post-oxidizing a partially oxidized titanium oxide thin film adjacent to a silver alloy thin film, a thin film formed by post-oxidizing a metal Ti thin film and a partially oxidized titanium oxide thin film adjacent to a silver alloy thin film, and the like. This is because these post-oxidation thin films have a larger effect due to post-oxidation, and therefore have a superior peeling inhibition effect for the thin film layer.

Examples of the post-oxidation thin film include, specifically, thin films formed by post-oxidizing a silver alloy thin film / a metal Ti thin film, a metal Ti thin film / a silver alloy thin film, a metal Ti thin film / a silver alloy thin film / a metal Ti thin film, a silver alloy thin film / a partially oxidized titanium oxide thin film, a partially oxidized titanium oxide thin film / a silver alloy thin film, a partially oxidized titanium oxide thin film / a silver alloy thin film / a partially oxidized titanium oxide thin film, a metal Ti thin film / a silver alloy thin film / a partially oxidized titanium oxide thin film, a partially oxidized titanium oxide thin film / a silver alloy thin film / a metal Ti thin film, and the like. One kind or two or more kinds of these post-oxidation thin films may be contained in the thin film layer.

Among these post-oxidation thin films, the thin films formed by post-oxidizing a metal Ti thin film / a silver alloy thin film / a metal Ti thin film, a partially oxidized titanium oxide thin film / a silver alloy thin film / a partially oxidized titanium oxide thin film, a metal Ti thin film / a silver alloy thin film / a partially oxidized titanium oxide thin film, a partially oxidized titanium oxide thin film / a silver alloy thin film / a metal Ti thin film, and the like are preferred from the point of view of, for example, being also likely to inhibit thermal diffusion of elements constituting the alloy, in addition to the peeling inhibition effect for the thin film layer. A thin film formed by post-oxidizing a metal Ti thin film / a silver alloy thin film / a metal Ti thin film is even more preferred from the point of view that, for example, equipment and devices for partial oxidation are unnecessary, in addition to the two effects mentioned above.

As an alloy constituting the alloy thin film, an alloy having low light absorption in the visible light range and being relatively easy to be oxidized is preferred. An alloy constituting the alloy thin film is a silver alloy from the point of view of the peeling inhibition effect for the thin film layer due to post-oxidation, having superior optical characteristics such as visible light transparency and heat ray reflectivity, and economic efficiency. A silver alloy containing one kind or two or more kinds of elements selected from Cu, Cr, Fe, Ni, Pb, Si, Ti, V, Y and Zr as secondary alloy elements is preferred. An Ag-Cu alloy is particularly preferred from the point of view of making it easy to be post-oxidized, making it easy to be phase separated, and the like, and an Ag-Ti alloy is particularly preferred from the point of view of being heat resistant and the like.

Further, it is desirable that content of the secondary alloy elements have a lower limit of preferably 0.01% by atom or more, more preferably 0.05% by atom or more, and even more preferably 0.1% by atom or more, from the point of view of making it easy to achieve a volume expansion effect and the like due to oxidation. On the other hand, it is desirable that the content of the secondary alloy elements have an upper limit of preferably 20% by atom or less, more preferably 10% by atom or less, and even more preferably 5% by atom or less, from the point of view of making it easy to ensure high transparency, making it easy to prepare a sputter target when thin film formation is performed using a sputtering method, and the like. In addition, percentages of the alloy elements can be measured by using ICP analysis.

When the Ag-Cu alloy is used, it is desirable that content of the copper have a lower limit of preferably 1% by atom or more, more preferably 2% by atom or more, and even more preferably 3% by atom or more, from the point of view of achieving an effect of addition. On the other hand, it is desirable that the content of the copper have an upper limit of preferably 20% by atom or less, more preferably 10% by atom or less, and even more preferably 5% by atom or less, from the point of view of manufacturing and the like, such as making it easy to ensure high transparency and making it easy to prepare a sputter target.

When the Ag-Ti alloy is used, it is desirable that content of the titanium have a lower limit of preferably 0.01% by atom or more, more preferably 0.05% by atom or more, and even more preferably 0.1% by atom or more, from the point of view of achieving an effect of addition. On the other hand, it is desirable that the content of the titanium have an upper limit of preferably 2% by atom or less, more preferably 1.75% by atom or less, and even more preferably 1.5% by atom or less, from the point of view of making it easy to ensure high transparency, making it easy to obtain a complete solid solution, and the like.

As a metal constituting the metal thin film, a metal is preferred that is relatively easy to be oxidized, has a Pilling-Bedworth ratio of greater than one, and has a highly transparent oxide. As the metal constituting the metal thin film, Ti is used from the point of view of being superior in balancing between the peeling inhibition effect for the thin film layer due to post-oxidation and optical characteristics in a sufficiently oxidized state.

As the metal oxide constituting the partially oxidized metal oxide thin film, the titanium oxide is used from the point of view of being superior in balancing between the peeling inhibition effect for the thin film layer due to post-oxidation and optical characteristics in a sufficiently oxidized state.

It is desirable that an atomic mole ratio, Ti / O ratio, of titanium with respect to oxygen in a thin film formed by post-oxidizing the metal Ti (which becomes a titanium oxide thin film) be within a range of preferably 1.0 / 1.0 - 1.0 / 2.0, more preferably 1.0 / 1.2 - 1.0 / 2.0, and even more preferably 1.0 / 1.4 - 1.0 / 2.0, from the point of view of the peeling inhibition effect, the optical characteristics, and the like.

Further, it is desirable that an atomic mole ratio, Ti / O ratio, of titanium with respect to oxygen in a thin film formed by post-oxidizing the partially oxidized titanium oxide (which becomes a titanium oxide thin film) is preferably 1.0 / 1.2 - 1.0 / 2.0, more preferably 1.0 / 1.4 - 1.0 / 2.0, and even more preferably 1.0 / 1.6 - 1.0 / 2.0, from the point of view of the peeling inhibition effect, optical characteristics, and the like.

The Ti / O ratios can be calculated from composition of the thin film. As a composition analysis method of the thin film, energy dispersive fluorescent X-ray analysis (EDX) can be preferably used, from the point of view of allowing the composition of an extremely thin film to be relatively accurately analyzed.

A specific composition analysis method is now explained. First, by using an ultra thin sectioning method (microtomy) and the like, a test specimen is prepared having a thickness of 100 nm or less in a cross sectional direction of the thin film layer containing the thin film to be analyzed. Next, the laminated structure and location of the thin film from the cross sectional direction are confirmed by using a transmission electron microscope (TEM). Next, an electron beam is emitted from an electron gun of an EDX equipment and is made incident to a vicinity of a thickness-wise central region of the thin film to be analyzed. Electrons made incident from a surface of the test specimen penetrate to a certain depth and generate various electron beams and X-rays. In this case, constituent elements of the thin film can be analyzed by detecting and analyzing characteristic X-rays.

A thin film formed by post-oxidizing the silver alloy thin film is contained in a post-oxidation thin film, and it is desirable that the thin film have a film thickness within a range of preferably 3 - 30 nm, more preferably 5 - 20 nm, and even more preferably 7 - 15 nm, from the point of view of visible light transparency, stability, heat ray reflectivity, conductivity, and the like.

When a thin film formed by post-oxidizing the metal Ti thin film is contained in a post-oxidation thin film, it is desirable that the thin film have a film thickness within a range of preferably 0.5 - 10 nm, more preferably 1 - 7 nm, and even more preferably 2 - 6 nm. This is because peeling at the thin film part (peeling within the thin film layer) becomes easily inhibited, and it also contributes to improvement in durability due to diffusion inhibition of the alloy elements.

When a thin film formed by post-oxidizing the partially oxidized titanium oxide thin film is contained in a post-oxidation thin film, it is desirable that the thin film have a film thickness within a range of preferably 0.5 -10 nm, more preferably 1 - 7 nm, and even more preferably 2 - 6 nm. This is because peeling at the thin film part (peeling within the thin film layer) becomes easily inhibited and it also contributes to improvement in durability due to diffusion inhibition of the alloy elements.

A post-oxidation thin film can be formed, for example, by forming a silver alloy thin film and at least one kind of thin film selected from a metal Ti thin film and a partially oxidized titanium oxide thin film, and then post-oxidizing the formed thin film by a post-processing such as a heat treatment, a chemical treatment, or by natural oxidation.

As a film formation method for a metal thin film, an alloy thin film and a partially oxidized metal oxide thin film, they may be preferably formed by a gas phase method from the point of view of allowing formation of a precise film and formation of a thin film having a uniform film thickness of about several nanometers to several tens of nanometers.

Examples of the gas phase method include, specifically, for example, physical vapor deposition methods (PVD) such as a vacuum deposition method, a sputtering method, an ion plating method, an MBE method and a laser ablation method; chemical vapor deposition methods (CVD) such as a thermal CVD method and a plasma CVD method; and the like. Among these methods, a sputtering method such as a DC magnetron sputtering method or an RF magnetron sputtering method can be preferably used from the point of view or allowing a precise film quality to be obtained, film thickness control is relatively easy, and the like.

In addition, a partially oxidized metal oxide thin film can be formed by introducing into a film formation atmosphere an amount of oxygen necessary for partial oxidation when forming a metal thin film constituting the metal oxide thin film.

Further, a method for post-oxidizing a formed metal thin film, alloy thin film or partially oxidized metal oxide thin film is not particularly limited. Examples of a post-oxidation method include a heat treatment, a pressure treatment, a chemical treatment, natural oxidation, and the like. Among these post-oxidation methods, the heat treatment is preferred from the point of view of being able to perform post-oxidation relatively simply and reliably. Examples of the heat treatment include, specifically, for example, heat treatment in a heating furnace or the like, warm water immersion treatment, microwave heating, electric current heating, and the like. Details are explained in section "2. The Present Production Method".

The basic configuration of the present film is as described above. However, the present film may further have formed on a surface of the thin film layer, a protective layer and the like formed by using a transparent resin such as an acrylic resin, a urethane resin, a polyester resin ir a cycloolefin resin. Having a protective layer provides advantages such as prevention of aggregation due to halogen and the like in an alloy thin film, prevention of damages to the thin film layer during working, and the like.

Examples of various uses of the present film include heat ray cutting, display electrodes of a display such as a liquid crystal display and a plasma display, touch panel electrodes, light control sheet electrodes, electromagnetic wave shields, gas (such as O₂ and H₂O) barrier films of an organic EL and the like, and the like. The present invention is particularly effective when used for heat ray cutting of a window glass and the like, which has more chances of being directly exposed to sunlight.

### 2. The Present Production Method

The present production method is a method capable of preferably producing the present film described above. The present production method includes at least the following lamination process and post-oxidation process.

In the present production method, the lamination process is a process forming a thin film layer on at least one surface of a transparent polymer film, containing a metal oxide thin film formed by a sol-gel method using light energy during sol-gel hardening, a silver alloy film and at least one kind of thin film selected from a metal Ti thin film and a partially oxidized titanium oxide thin film.

Specifically, for example, a thin film layer is formed on one surface of a transparent polymer film containing, in order starting from the transparent polymer film side, a metal oxide thin film (1 st layer) | a metal Ti thin film / a silver alloy thin film / a metal Ti thin film (2nd layer) | a metal oxide thin film (3rd layer) | a metal Ti thin film / a silver alloy thin film / a metal Ti thin film (4th layer) | a metal oxide thin film (5th layer) | a metal Ti thin film / a silver alloy thin film / a metal Ti thin film (6th layer) | a metal oxide thin film (7th layer), and the like.

Here, in the lamination process, a silver alloy thin film and at least one kind of thin film selected from a metal Ti thin film and a partially oxidized titanium oxide thin film contained in the thin film layer are not aggressively oxidized. This is because, in the present production method, these are aggressively oxidized in the post-oxidation process that follows the lamination process. However, it does not exclude a case where the each thin film is naturally lightly oxidized in the lamination process.

In addition, the material of the transparent polymer film, the type, material, film thickness and laminating order of the formed metal oxide thin film, metal Ti thin film, silver alloy thin film and partially oxidized titanium oxide thin film, the film formation methods of each thin film, and the like, are as described above, and therefore explanation thereof is omitted.

Next, in the present production method, the post-oxidation process is a process in which a silver alloy thin film and at least one kind of thin film selected from a metal Ti thin film and a partially oxidized titanium oxide thin film, contained in the thin film layer formed by the lamination process, are post-oxidized to form a post-oxidation thin film. Via the post-oxidation process, a metal thin film and the like are post-oxidized by consuming oxygen sources such as moisture and oxygen contained in the air or in the metal oxide thin film formed by a sol-gel method.

In the post-oxidation process, the post-oxidation method is not particularly limited. Examples of the post-oxidation method include heat treatment, pressure treatment, chemical treatment, natural oxidation, and the like. Among these post-oxidation methods, the heat treatment is preferred from the point of view of being able to perform post-oxidation relatively simply and reliably. Examples of the heat treatment include, for example, a method in which the transparent polymer film having the thin film layer (before post-oxidation) is placed in a heating atmosphere such as a heating furnace, a warm water immersion method, a microwave heating method, an electric current heating method in which an electric current is supplied to a metal thin film, an alloy thin film and a partially oxidized metal oxide thin film, and the like. One or a combination of two or more of these methods may be performed.

When post-oxidizing a transparent polymer film having a thin film layer (before post-oxidation), examples of a form of the film include forms such as a roll-like form and a belt-like form. When the film is wound in a roll-like form, it is suitable for performing batch processing with a heating furnace and the like, and is superior with respect to storage. On the other hand, when the film is stretched in a belt-like form, it is suitable for performing continuous processing using heating equipment and the like provided on a continuous line.

Heating conditions during a heat treatment are different depending on the heating methods described above. Among the heating conditions, for example, it is preferable that a heating temperature is equal to or below the softening temperatures of materials constituting the transparent polymer film and the thin film layer. This is for inhibiting deformation, thermal fusion bonding, and the like due to heating. It is particularly preferable that the heating temperature is equal to or below a softening temperature of a material having the lowest softening temperature among the materials constituting the transparent polymer film and the thin film layer. The effect of this is particularly great when the transparent polymer film having the thin film layer (before post-oxidation) is wound in a roll-like form.

It is desirable that the heating conditions during a heat treatment be selected from, specifically, for example, a heating temperature of preferably 30 °C - 60 °C, more preferably 32 °C - 57 °C, and even more preferably 35 °C - 55 °C, and when placed in a heating atmosphere, selected from a heating time of preferably 5 days or more, more preferably 10 days or more, and even more preferably 15 days or more. This is because the balance is good between a post-oxidation effect, a thermal deformation and fusion bonding inhibition effect, and the like, when the heating conditions are within the above ranges. The above advantages are particularly easy to achieve when a transparent polymer constituting the transparent polymer film is a polyester resin such as a polyethylene terephthalate, when the transparent polymer film having the thin film layer (before post-oxidation) is wound in a roll-like form, and the like.

Further, it is desirable that the heating atmosphere during a heat treatment be an atmosphere having oxygen and moisture such as the air, a high oxygen atmosphere and high humidity atmosphere. The air is particularly preferred from the point of view of manufacturing, cost reduction, and the like.

### Working Examples

In the following, the present invention is explained in detail using working examples and a comparative example.

### 1. Preparation of Transparent Laminated Film

As transparent laminated films according to working examples 1 - 4, a reference example 5 and a comparative example 1, transparent laminated films having a thin film layer of roughly the following 7-layer laminated structure were prepared.

That is, the transparent laminated films according to working examples 1 - 4 have a thin film layer in which a TiO₂ thin film formed by a sol-gel method and ultraviolet irradiation (1st layer) | a thin film formed by post-oxidizing a metal Ti thin film / an Ag-Cu alloy thin film / a metal Ti thin film (2nd layer) | a TiO₂ thin film formed by a sol-gel method and ultraviolet irradiation (3rd layer) | a thin film formed by post-oxidizing a metal Ti thin film / an Ag-Cu alloy thin film / a metal Ti thin film (4th layer) | a TiO₂ thin film formed by a sol-gel method and ultraviolet irradiation (5th layer) | a thin film formed by post-oxidizing a metal Ti thin film / an Ag-Cu alloy thin film / a metal Ti thin film (6th layer) | a TiO₂ thin film formed by a sol-gel method and ultraviolet irradiation (7th layer) are laminated in order on one surface of a transparent polymer film.

In addition, the metal Ti thin films, as thin films accompanying the Ag-Cu alloy thin films, are included with the Ag-Cu alloy thin films for lamination layer counting. Further, the post-oxidation is, specifically, a thermal oxidation.

The transparent laminated film according to reference example 5 is largely different from the transparent laminated films according to working examples 1 - 4 in that thin films formed by post-oxidizing Ag-Cu alloy thin films alone are used for the 2nd, 4th and 6th layers.

The transparent laminated film according to comparative example 1 is largely different from the transparent laminated films according to working examples 1 - 4 in that, in the 2nd, 4th and 6th layers, instead of post-oxidation thin films, titanium oxide thin films formed as oxide thin films from the beginning during lamination are used, and in that Ag-Bi alloy thin films are used in place of Ag-Cu alloy thin films.

As a transparent laminated film according to working example 6, a transparent laminated film having a thin layer of roughly the following 3-layer laminated structure was prepared.

That is, the transparent laminated film according to working example 6 has a thin film layer in which a TiO₂ thin film formed by a sol-gel method and ultraviolet irradiation (1st layer) | a thin film formed by post-oxidizing a metal Ti thin film / an Ag-Ti alloy thin film / a metal Ti thin film (2nd layer) | a TiO₂ thin film formed by a sol-gel method and ultraviolet irradiation (3rd layer) are laminated in order on one surface of a transparent polymer film.

In addition, the metal Ti thin films, as thin films accompanying the Ag-Ti alloy thin film, are included with the Ag-Ti alloy thin film for lamination layer counting. Further, the post-oxidation is, specifically, a thermal oxidation.

In the following, specific preparation steps of the transparent laminated films according to the working examples, the reference example and the comparative example are illustrated.

### (Preparation of Coating Liquid)

First, a coating liquid to be used in forming a TiO₂ thin film by a sol-gel method was prepared. That is, the coating liquid was prepared by combining tetra-n-butoxy titanium tetramer ("B4", manufactured by Nippon Soda Co., Ltd.) as titanium alkoxide and acetylacetone as an additive forming an ultraviolet light-absorbing chelate with a mixed solution of n-butanol and isopropyl alcohol, and mixing the combination for 10 minutes using a stirrer. In this case, the combination of tetra-n-butoxy titanium tetramer / acetylacetone / n-butanol / isopropyl alcohol was respectively 6.75% by mass / 3.38% by mass / 59.87% by mass / 30.00% by mass.

### (Lamination of Each Thin Film: 7-layer Laminated Structure)

As the transparent polymer film, a polyethylene terephthalate film having a thickness of 50 µm with an easy adhesion layer formed on one surface thereof ("COSMOSHINE (registered trademark) A4100"manufactured by Toyobo Co., Ltd.) (referred to as "PET film" in the following) was used. On one surface (the PET surface) side of the PET film, which is opposite to the easy adhesion layer surface side, a TiO₂ thin film was formed as a 1^{st} layer by the following steps.

That is, using a micro gravure coater, the coating liquid was continuously coated on the PET surface side of the PET film with gravure rolls each having a predetermined groove volume. Next, using an inline drying furnace, the coated film was dried for 80 seconds at a temperature of 100 °C, and a precursor film of a TiO₂ thin film was formed. Next, by using inline ultraviolet light irradiation equipment [a high pressure mercury lamp (160 W/cm)], ultraviolet light was continuously irradiated on the precursor film for 1.5 seconds at a same line speed as during coating. By doing this, a TiO₂ thin film (1st layer) was formed on the PET film by a sol-gel method using ultraviolet light energy during sol-gel hardening (may be abbreviated as "sol-gel + UV" in the following).

Next, on top of the 1st layer, each thin film constituting a 2nd layer was formed.

That is, for working examples 1 - 4, a lower side metal Ti thin film was formed on top of the 1st layer TiO₂ thin film by sputtering using DC magnetron sputter equipment. Next, an Ag-Cu alloy thin film was formed on top of the lower side metal Ti thin film by sputtering. Next, an upper side metal Ti thin film was formed on top of the Ag-Cu alloy thin film by sputtering.

Further, for reference example 5, an Ag-Cu alloy thin film was formed on top of the 1st layer TiO₂ thin film by sputtering using DC magnetron sputter equipment. That is, in reference example 5, upper and lower side metal Ti thin films were not formed.

Further, for comparative example 1, a lower side titanium oxide thin film was formed on top of the 1st layer TiO₂ thin film by reactive sputtering using DC magnetron sputter equipment. Next, an Ag-Bi alloy thin film was formed on top of the lower side titanium oxide thin film by sputtering. Next, an upper side titanium oxide thin film was formed on top of the Ag-Bi alloy thin film by reactive sputtering.

In this case, in working examples 1 - 4, film formation conditions for the upper and lower side metal Ti thin films were: Ti target (purity 4N); ultimate vacuum pressure: 5 × 10⁻⁶ (Torr); inert gas: Ar; gas pressure: 2.5 × 10⁻³ (Torr); input power: 1.5 (kW) (working example 1), 4.4 (kW) (working example 2), 0.7 (kW) (working example 3), and 5.1 (kW) (working example 4); and film formation time: 1.1 seconds. Film thickness was varied by varying the input power.

Further, in working examples 1 - 4, film formation conditions for the Ag-Cu alloy thin film were: Ag-Cu alloy target (Cu content: 4% by atom); ultimate vacuum pressure: 5 × 10⁻⁶ (Torr); inert gas: Ar; gas pressure: 2.5 × 10⁻³ (Torr); input power: 1.5 (kW); and film formation time: 1.1 seconds.

On the other hand, in comparative example 1, film formation conditions for the upper and lower side titanium oxide thin films were: Ti target (purity 4N); ultimate vacuum pressure: 5 × 10⁻⁶ (Torr); inert gas: Ar; reactive gas: O₂; gas flow ratio: Ar / O₂ = 100 / 20; gas pressure: 2.5 × 10⁻³ (Torr); input power: 7.9 (kW); and film formation time: 1.1 seconds.

Further, in comparative example 1, film formation conditions for the Ag-Bi alloy thin film were: Ag-Bi alloy target (Bi content: 0.5% by atom); ultimate vacuum pressure: 5 × 10⁻⁶ (Torr); inert gas: Ar; gas pressure: 2.5 × 10⁻³ (Torr); input power: 1.2 (kW); and film formation time: 1.1 seconds.

Next, as a 3rd layer, a TiO₂ thin film was formed by "sol-gel + UV" on top of the 2nd layer. Here, a predetermined film thickness was obtained by performing the film formation steps twice according to the 1st layer.

Next, as a 4th layer, each thin film constituting the 4th layer was formed on top of the 3rd layer. Here, film formation steps according to the 2nd layer were performed.

In this regard, for working examples 1 - 4, film formation conditions for the Ag-Cu alloy thin film were: Ag-Cu alloy target (Cu content: 4% by atom); ultimate vacuum pressure: 5 × 10⁻⁶ (Torr); inert gas: Ar; gas pressure: 2.5 × 10⁻³ (Torr); input power: 1.8 (kW); and film formation time: 1.1 seconds.

Further, in comparative example 1, film formation conditions for the Ag-Bi alloy thin film were: Ag-Bi alloy target (Bi content: 0.5% by atom); ultimate vacuum pressure: 5 × 10⁻⁶ (Torr); inert gas: Ar; gas pressure: 2.5 × 10⁻³ (Torr); input power: 1.5 (kW); and film formation time: 1.1 seconds.

Next, as a 5th layer, similar to the 3rd layer, a TiO₂ thin film was formed by "sol-gel + UV" on top of the 4th layer.

Next, as a 6th layer, similar to the 2nd layer, each thin film was formed on top of the 5th layer.

Next, as a 7th layer, a TiO₂ thin film was formed by "sol-gel + UV" on top of the 6th layer. Here, a predetermined film thickness was obtained by performing the film formation steps once according to the 1st layer.

Thereafter, for working examples 1 - 4 and reference example 5, the transparent laminated film having the thin film layer obtained via the lamination process was heat treated in the air within a heating furnace at a temperature of 40 °C for 300 hours to post-oxidize the metal Ti thin films / Ag-Cu alloy thin films / metal Ti thin films (the 2nd, 4th, and 6th layers of working examples 1 - 4) or the Ag-Cu alloy thin films (the 2nd, 4th, and 6th layers of reference example 5), contained in the thin film layer. Thereby, the transparent laminated films according to working examples 1 - 4 and reference example 5 were prepared.

On the other hand, for comparative example 1, the post-oxidation process was not performed with respect to the transparent laminated film having the thin film layer obtained via the lamination process. That is, the transparent laminated film having the thin film layer obtained via the lamination process became the transparent laminated film according to comparative example 1 as-is.

### (Lamination of Each Thin Film: 3-layer Laminated Structure)

To prepare the transparent laminated film according to working example 6, similar to working example 1, a TiO₂ thin film (the 1st layer) was formed by "sol-gel + UV" on the PET surface side of the PET film.

Next, on top of the 1st layer, each thin film constituting a 2nd layer was formed.

That is, a lower side metal Ti thin film was formed on top of the 1st layer TiO₂ thin film by sputtering using DC magnetron sputter equipment. Next, an Ag-Ti alloy thin film was formed on top of the lower side metal Ti thin film by sputtering. Next, an upper side metal Ti thin film was formed on top of the Ag-Ti alloy thin film by sputtering.

In this case, film formation conditions for the upper and lower side metal Ti thin films were as follows: Ti target (purity 4N); ultimate vacuum pressure: 5 × 10⁻⁶ (Torr); inert gas: Ar; gas pressure: 2.5 × 10⁻³ (Torr); input power: 1.5 (kW); and film formation time: 1.1 seconds.

Film formation conditions for the Ag-Ti alloy thin film were as follows: Ag-Ti alloy target (Ti content: 1% by atom); ultimate vacuum pressure: 5 × 10⁻⁶ (Torr); inert gas: Ar; gas pressure: 2.5 × 10⁻³ (Torr); input power: 1.5 (kW); and film formation time: 1.1 seconds.

Thereafter, the transparent laminated film having the thin film layer obtained via the lamination process was heat-treated in a heating furnace in the air at a temperature of 40 °C for 300 hours to post-oxidize the metal Ti thin film / Ag-Ti alloy thin film / metal Ti thin film (the 2nd layer) contained in the thin film layer. Thereby, the transparent laminated film according to working example 6 was prepared.

With respect to the transparent laminated films according to examples 1 - 6 and the transparent laminated film according to comparative example 1, refractive indices of the TiO₂ thin films (for a measurement wavelength of 633 nm) were measured by using a FilmTek 3000 (manufactured by Scientific Computing International).

Contents of the organic components contained in the TiO2 thin films were measured by using X-ray photoelectron spectroscopy (XPS).

With respect to the titanium oxide thin films formed by post-oxidizing the metal Ti thin films (working examples 1 - 4 and 6) and the titanium oxide thin films formed by reactive sputtering (comparative example 1), EDX analyses were performed, and Ti / O ratios were obtained as follows.

That is, a test specimen having a thickness of 100 nm or less in a cross sectional direction of the laminated structure containing the titanium oxide thin film to be analyzed was prepared by cutting a transparent laminated film using a microtome ("ultrome V2088" manufactured by LKB). A cross section of the prepared test specimen was confirmed by using a field emission electron microscopy (HRTEM) ("JEM2001F" manufactured by JEOL Ltd.). Next, by using EDX equipment (having a spectral resolution of 133 eV or less) ("JED-2300T" manufactured by JEOL Ltd.), an electron beam was emitted from an electron gun of the EDX equipment and was made incident to a vicinity of a thickness-wise central region of the titanium oxide thin film to be analyzed. Analysis of constituent elements of the titanium oxide thin film was performed by detecting and analyzing generated characteristic X-rays.

Contents of the secondary elements contained in the alloy thin films (examples 1 - 5 : Cu; working example 6 : Ti; comparative example 1 : Bi) were obtained as follows. That is, under each film formation condition, a test specimen was separately prepared by forming a predetermined alloy thin film on a glass substrate. The test specimen was immersed in a solution containing 6% of HNO₃. After performing elution by ultrasound for 20 minutes, the obtained sample solution was used to perform a measurement using a concentration method of an ICP analysis method.

Thickness of each of the thin films was measured by cross-sectional observation of the test specimen by using the field emission electron microscopy (HRTEM) ("JEM2001F" manufactured by JEOL Ltd.).

Tables 1 and 2 illustrate detailed lamination configurations of the transparent laminated films according to the working examples, reference example and comparative example.

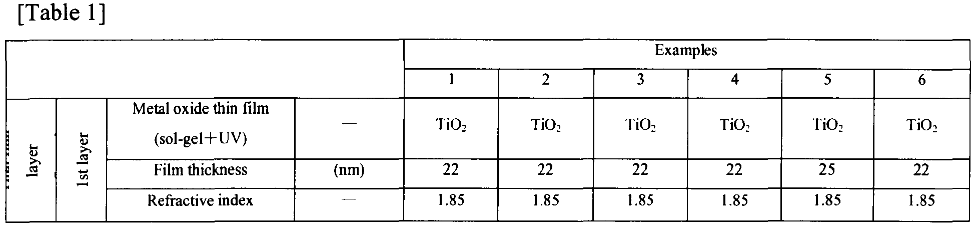

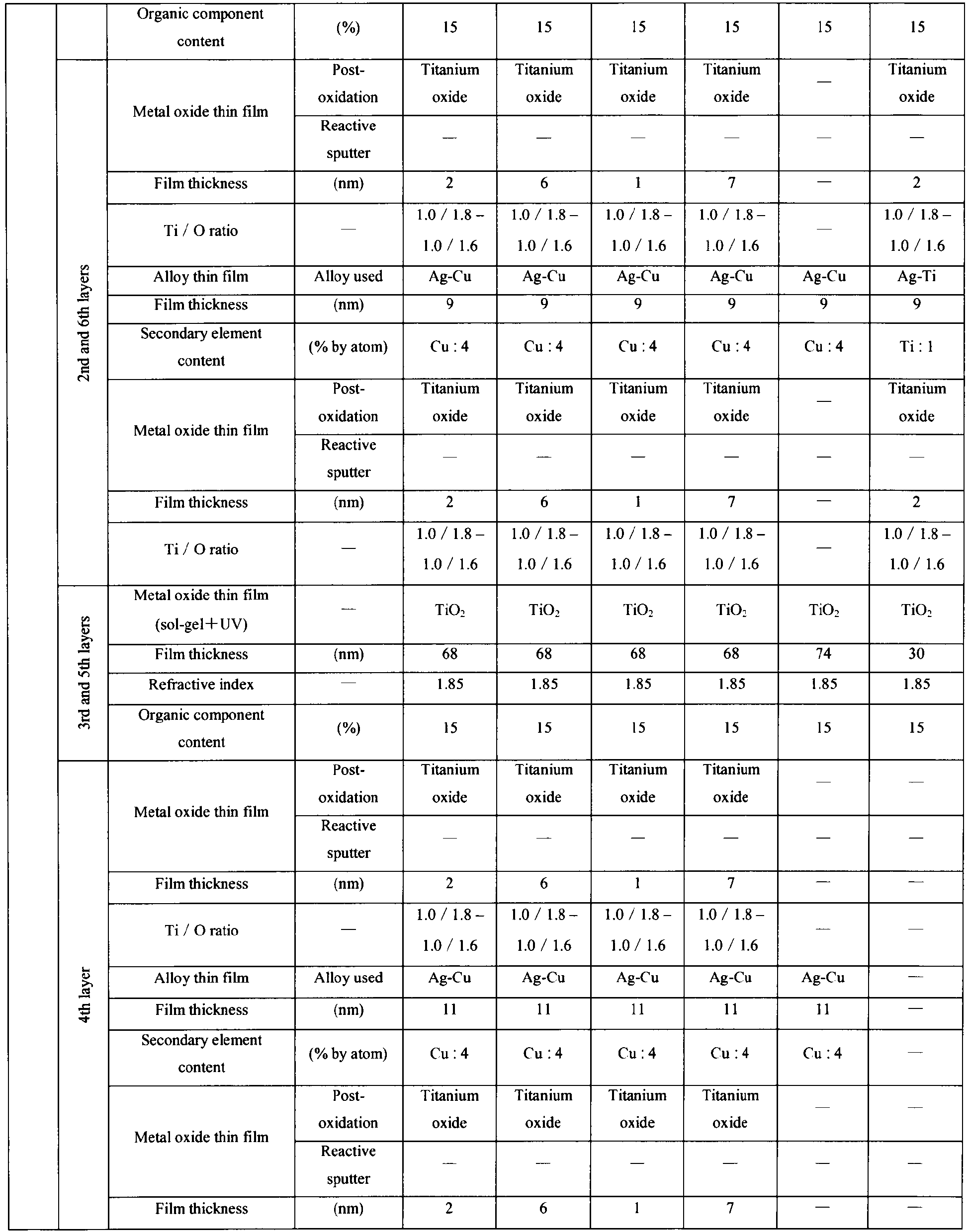

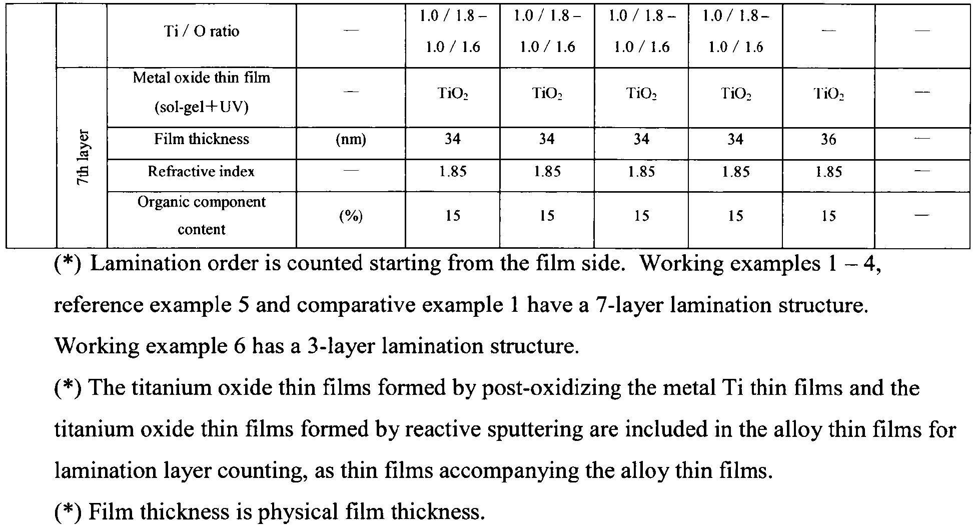

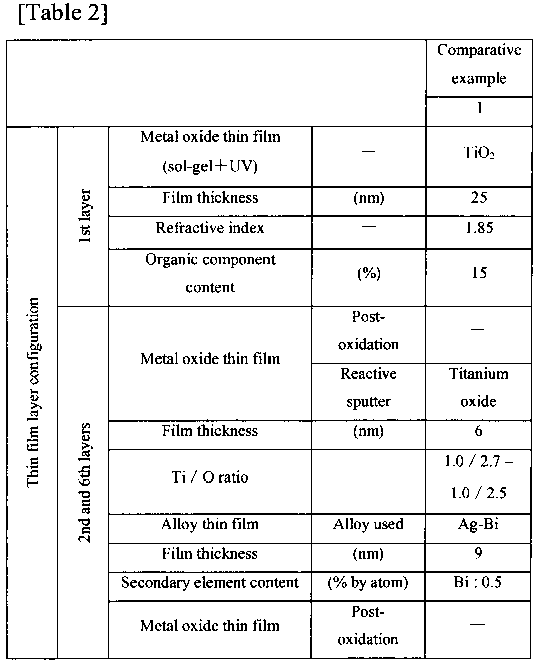

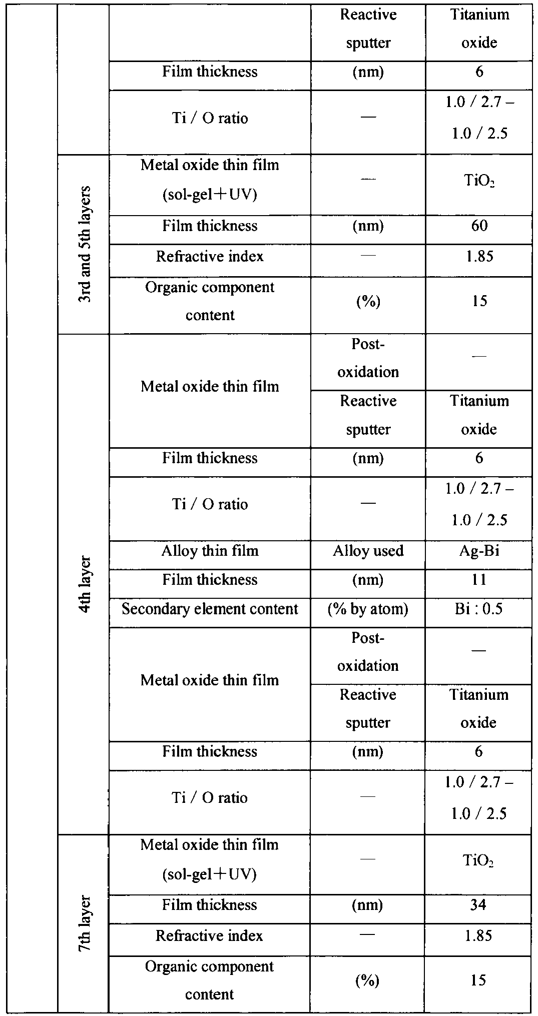

### 2. Optical Characteristics and Evaluation of Transparent Laminated Films

### 2.1 Optical Characteristics

With respect to each of the prepared transparent laminated films, the following optical characteristics were measured. A measurement sample used for the measurement was prepared by pasting an acryl adhesive sheet having a thickness of 25 µm ("CS9621" manufactured by Nitto Denko Corporation) on the thin film layer surface side of the transparent laminated film, and pasting an adhesive layer of the adhesive sheet on one surface of a float glass having a thickness of 3 mm. Measurement light was made incident from a glass surface side during evaluation of optical characteristics.

### (Solar Light Transmittance)

Transmission spectrum in a wavelength of 300 - 2500 nm was measured by using a spectral photometer ("UV 3100"manufactured by Shimadzu Corporation) in accordance with JIS A5759, and solar light transmittance was obtained by calculation.

### (Shading Coefficient)

After specified parameters were measured in accordance with JIS A5759, a shading coefficient was obtained by calculation.

### (Visible Light Transmittance, Visible Light Reflectance)

Transmission spectrum in a wavelength of 300 - 1000 nm was measured by using a spectral photometer ("UV 3100"manufactured by Shimadzu Corporation) in accordance with JIS A5759, and visible light transmittance and visible light reflectance were obtained by calculation.

### 2.2 Evaluation

With respect to each of the prepared transparent laminated films, the following ultraviolet light (UV light) irradiation test, tape peeling test, and heat resistance test were performed. The UV light irradiation test is a test to investigate occurrence of peeling at an interface between the transparent polymer film and the thin film layer due to UV light irradiation. The tape peeling test is a test to investigate occurrence of peeling within the thin film layer. The heat resistance test is a test to investigate existence or non-existence of thermal diffusion of Ag constituting an alloy thin film.

### (UV Light Irradiation Test)

Ultraviolet light (160 W / cm²) was irradiated from a float glass side of a sample for 1000 hours using ultraviolet irradiation equipment (Light source: Xenon lamp, "Super Xenon Weather Meter SX75" manufactured by Suga Test Instruments Co., Ltd.), the sample being prepared by applying an acrylic adhesive ("CLEARED 22" manufactured by TOYOHOZAI Co., Ltd.) to the thin film layer side surface of the transparent laminated film and being glued on one surface of the float glass, the acrylic adhesive having a thickness of 22 µm with an ultraviolet absorbing agent added therein, and the float glass having a thickness of 3 mm. Existence or non-existence of peeling at the interface between the PET film and the thin film layer was visually confirmed. The result was determined as "Pass" when peeling of the thin film layer of the transparent laminated film sample did not occur, and as "Fail" when peeling of the thin film layer did occur.

### (Tape Peeling Test)

A mending tape ("810" manufactured by Sumitomo 3M Ltd.) was pasted on the surface of the thin film layer of a transparent laminated film sample (shape: 50 mm × 50 mm) in a perpendicular direction with respect to an edge of the sample. A 180 degree peeling test was performed, and existence or non-existence of peeling was visually confirmed. The result was determined as "A" when peeling of the thin film layer of the transparent laminated film sample (including peeling within the thin film layer) did not occur, and as "B" when peeling of the thin film layer (including peeling within the thin film layer) did occur.

### (Heat Resistance Test)

A transparent laminated film sample (shape: 50 mm × 50 mm) was heated at a temperature of 80 °C for 1000 hours, and existence or non-existence of thermal diffusion of Ag constituting an alloy thin film was confirmed based on surface resistance. The result was determined as "A" when thermal diffusion of Ag did not occur and no change was observed before and after the test, and as "B" when thermal diffusion of Ag did occur.

Table 3 summarizes measured optical characteristics and evaluation results with respect to each of the transparent laminated films.

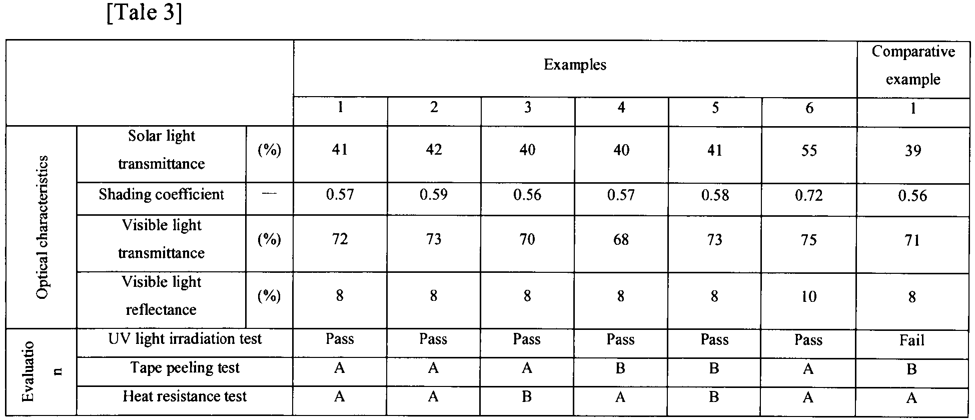

From Tables 1 - 3, the following is clear. That is, the transparent laminated film according to comparative example 1 does not have post-oxidation thin films. Therefore, it is clear that, when irradiated by UV light for a long period of time, peeling of the thin film layer occurs.

This can be understood as due to the following. A starting material remaining in the TiO2 thin films formed by "sol-gel + UV" reacted with moisture (such as adsorbed water), oxygen, and the like, causing hardening contraction to progress and internal stress to occur, which resulted in peeling at the interface between the PET film and the thin film layer, which is the weakest site.

In contrast, the transparent laminated films according to examples 1 - 6 have, in the thin film layers, the TiO₂ thin films formed by "sol-gel + UV" and the post-oxidation thin films formed by post-oxidizing the metal Ti thin films and Ag alloy thin films. Therefore, it is clear that, even when irradiated by UV light for a long period of time, peeling of the thin film layer can be inhibited.

This can be understood as due to the following. During formation of the post-oxidation thin films, volume expansion occurred due to oxidation of the metal Ti, Ag-Cu alloy, and Ag-Ti alloy, which relieved internal stress occurring due to sol-gel hardening contraction. Further, during formation of the post-oxidation thin films, adsorbed water, oxygen, and the like, that are contained in the TiO₂ thin films formed by "sol-gel + UV", were consumed, and therefore, even when irradiated by UV light for a long period of time, sol-gel hardening was less likely to occur so that occurrence of internal stress was inhibited.

By making a comparison between working examples 1 and 2 and working examples 3 and 4, it is clear that, when the film thickness of the thin films formed by post-oxidizing the metal Ti thin films is with a range of 2 - 6 nm, in addition to a peeling inhibition effect of the thin film layer, it is also easy to inhibit peeling within the thin film layer and thermal diffusion of Ag.

By making a comparison between working examples 1 - 4 and reference example 5, it is clear that it is easier to inhibit peeling within the thin film layer and thermal diffusion of Ag in the case of using a post-oxidation thin film formed by post-oxidizing a thin film having metal Ti thin films (metal thin films) formed on both sides of an Ag-Cu alloy thin film (alloy thin film) (working examples 1 - 4) than in the case of using a post-oxidation thin film formed by post-oxidizing an Ag-Cu alloy thin film (alloy thin film) alone (reference example 5).

A case of using a post-oxidation thin film formed by post-oxidizing a thin film having a Ti thin film (metal thin film) formed on one surface of an Ag-Cu alloy thin film (alloy thin film) has not been particularly illustrated. However, it can be easily analogized that, in this case, it is also easier to inhibit peeling within the thin film layer and thermal diffusion of Ag than in the case of reference example 5.

For working example 6, there are 3 lamination layers, and a post-oxidation thin film formed by post-oxidizing a thin film having metal Ti thin films (metal thin films) formed on both sides of an Ag-Ti alloy thin film (alloy thin film) is used. It is clear that, for such a configuration, similar effects as in working examples 1 and 2 can also be obtained.

In the above, the embodiments and working examples of the present invention were explained. However, the present invention is not in any way limited to the embodiments and working examples. Various modifications are possible without departing from the scope of the present invention.

## Claims

1. A transparent laminated film comprising:
a transparent polymer film; and
a thin film layer formed on at least one surface of the transparent polymer film by laminating a plurality of thin films,
wherein, the thin film layer comprises:
a metal oxide thin film formed by a sol-gel method using light energy during sol-gel hardening; and
a post-oxidation thin film formed by post-oxidizing a silver alloy thin film and at least one kind of thin film selected from a metal Ti thin film and a partially oxidized titanium oxide thin film, and
wherein the post-oxidation thin film formed by post-oxidizing at least one of the metal Ti thin film and the partially oxidized titanium oxide thin film exists adjacent to the post-oxidation thin film formed by post-oxidizing the silver alloy thin film.

2. The transparent laminated film according to claim 1, wherein the thin film layer contains a metal oxide thin film formed by a sol-gel method using light energy during sol-gel hardening and arranged in contact with the transparent polymer film.

3. The transparent laminated film according to claim 1 or 2, wherein, when the post-oxidation thin film contains at least one of a thin film formed by post-oxidizing the metal Ti thin film and a thin film formed by post-oxidizing the partially oxidized titanium oxide thin film, the thin film has a film thickness within a range of 2 - 6 nm.

4. The transparent laminated film according to any one of claims 1 to 3, wherein the silver alloy contains at least one kind of element selected from Cu, Cr, Fe, Ni, Pb, Si, Ti, V, Y, and Zr, as secondary alloy elements.

5. The transparent laminated film according to any one of claims 1 to 4, wherein the silver alloy is one of an Ag-Cu alloy and an Ag-Ti alloy.

6. The transparent laminated film according to any one of claims 1 - 5, wherein the film is for heat ray cutting.

7. The transparent laminated film according to any one of claims 1 - 6, wherein the post-oxidation thin film is laminated between the metal oxide thin film formed by a sol-gel method and the metal oxide thin film formed by a sol-gel method.

8. A transparent laminated film production method comprising:
a lamination process forming, on at least one surface of a transparent polymer film, a thin film layer containing a metal oxide thin film formed by a sol-gel method using light energy during sol-gel hardening, a silver alloy thin film and at least one kind of thin film selected from a metal Ti thin film and a partially oxidized titanium oxide thin film; and
a post-oxidation process forming a post-oxidation thin film by post-oxidizing the silver alloy thin film and the at least one kind of thin film selected from the metal Ti thin film and the partially oxidized titanium oxide thin film, the post-oxidation thin film being contained in the thin film layer.

9. The transparent laminated film production method according to claim 8, wherein the post-oxidation process is performed by post-oxidizing the transparent polymer film having the thin film layer.

10. The transparent laminated film production method according to claim 9, wherein the transparent polymer film having the thin film layer is wound in a roll-like form.

11. The transparent laminated film production method according to any one of claims 8 - 10, wherein the post-oxidation is performed via a heat treatment.

12. The transparent laminated film production method according to claim 11, wherein a heating temperature during the heat treatment is equal to or below a softening temperature of a material constituting the transparent polymer film having the thin film layer.

## Patentansprüche

1. Lichtdurchlässiger, laminierter Film, umfassend:
einen lichtdurchlässigen Polymerfilm; und
eine Dünnfilmschicht, die auf mindestens einer Oberfläche des lichtdurchlässigen Polymerfilms durch Laminieren einer Mehrzahl von Dünnfilmen gebildet ist,
wobei die Dünnfilmschicht umfasst:
einen Metalloxid-Dünnfilm, gebildet durch ein Sol-Gel-Verfahren unter Verwendung von Lichtenergie während des Sol-Gel-Härtens; und
einen Nachoxidation-Dünnfilm, gebildet durch Nachoxidieren eines Silberlegierung-Dünnfilms und mindestens einer Art von Dünnfilm, ausgewählt aus einem metallischen Ti-Dünnfilm und einem teilweise oxidierten Titanoxid-Dünnfilm, und
wobei der Nachoxidation-Dünnfilm, gebildet durch Nachoxidieren mindestens eines von dem metallischen Ti-Dünnfilm und dem teilweise oxidierten Titanoxid-Dünnfilm, angrenzend an den Nachoxidation-Dünnfilm, gebildet durch Nachoxidieren des Silberlegierung-Dünnfilms, existiert.

2. Lichtdurchlässiger, laminierter Film nach Anspruch 1, wobei die Dünnfilmschicht einen Metalloxid-Dünnfilm enthält, der durch ein Sol-Gel-Verfahren unter Verwendung von Lichtenergie während des Sol-Gel-Härtens gebildet ist und in Kontakt mit dem lichtdurchlässigen Polymerfilm angeordnet ist.

3. Lichtdurchlässiger, laminierter Film nach Anspruch 1 oder 2, wobei, wenn der Nachoxidation-Dünnfilm mindestens einen von einem Dünnfilm, gebildet durch Nachoxidieren des metallischen Ti-Dünnfilms, und einem Dünnfilm, gebildet durch Nachoxidieren des teilweise oxidierten Titanoxid-Dünnfilms, enthält, der Dünnfilm eine Filmdicke in einem Bereich von 2 - 6 nm aufweist.

4. Lichtdurchlässiger, laminierter Film nach einem der Ansprüche 1 bis 3, wobei die Silberlegierung mindestens eine Art Element, ausgewählt aus Cu, Cr, Fe, Ni, Pb, Si, Ti, V, Y und Zr, als zweite Legierungselemente enthält.

5. Lichtdurchlässiger, laminierter Film nach einem der Ansprüche 1 bis 4, wobei die Silberlegierung eine von einer Ag-Cu-Legierung und einer Ag-Ti-Legierung ist.

6. Lichtdurchlässiger, laminierter Film nach einem der Ansprüche 1 bis 5, wobei der Film zum Warmstrahlschneiden ist.

7. Lichtdurchlässiger, laminierter Film nach einem der Ansprüche 1 bis 6, wobei der Nachoxidation-Dünnfilm zwischen dem Metalloxid-Dünnfilm, gebildet durch ein Sol-Gel-Verfahren, und dem Metalloxid-Dünnfilm, gebildet durch ein Sol-Gel-Verfahren, laminiert ist.

8. Verfahren zur Herstellung eines lichtdurchlässigen, laminierten Films, umfassend:
einen Laminierungsvorgang, der auf mindestens einer Oberfläche eines lichtdurchlässigen Polymerfilms eine Dünnfilmschicht bildet, die einen Metalloxid-Dünnfilm, gebildet durch ein Sol-Gel-Verfahren, das Lichtenergie während dem Sol-Gel-Härten verwendet, einen Silberlegierung-Dünnfilm und mindestens eine Art von Dünnfilm, ausgewählt aus einem metallischen Ti-Dünnfilm und einem teilweise oxidierten Titanoxid-Dünnfilm, enthält; und
einen Nachoxidationsvorgang, der einen Nachoxidation-Dünnfilm durch Nachoxidieren des Silberlegierung-Dünnfilms und der mindestens einen Art von Dünnfilm, ausgewählt aus einem metallischen Ti-Dünnfilm und einem teilweise oxidierten Titanoxid-Dünnfilm, bildet, wobei der Nachoxidation-Dünnfilm in der Dünnfilmschicht enthalten ist.

9. Verfahren zur Herstellung eines lichtdurchlässigen, laminierten Films nach Anspruch 8, wobei der Nachoxidationsvorgang durch Nachoxidieren des lichtdurchlässigen Polymerfilms mit der Dünnfilmschicht durchgeführt wird.

10. Verfahren zur Herstellung eines lichtdurchlässigen, laminierten Films nach Anspruch 9, wobei der lichtdurchlässige Polymerfilm mit der Dünnfilmschicht in eine rollenartige Form gewunden wird.

11. Verfahren zur Herstellung eines lichtdurchlässigen, laminierten Films nach einem der Ansprüche 8 - 10, wobei die Nachoxidation durch eine Wämebehandlung durchgeführt wird.

12. Verfahren zur Herstellung eines lichtdurchlässigen, laminierten Films nach Anspruch 11, wobei eine Erwärmungstemperatur während der Wärmebehandlung gleich zu oder unterhalb einer Erweichungstemperatur eines Materials, das den lichtdurchlässigen Polymerfilm mit der Dünnfilmschicht bildet, ist.

## Revendications

1. Film stratifié transparent comprenant :
un film polymère transparent ; et
une couche de film fin formée sur au moins une surface du film polymère transparent en stratifiant une pluralité de films fins,
dans lequel la couche de film fin comprend :
un film fin en oxyde métallique formé par un procédé sol-gel en utilisant de l'énergie lumineuse au cours du durcissement sol-gel ; et
un film fin de post-oxydation formé en post-oxydant un film fin en alliage d'argent et au moins un type de film fin sélectionné parmi un film fin en Ti métallique et un film fin en oxyde de titane partiellement oxydé, et
dans lequel le film fin de post-oxydation formé en post-oxydant au moins un du film fin en Ti métallique et du film fin en oxyde de titane partiellement oxydé existe de manière adjacente au film fin de post-oxydation formé en post-oxydant le film fin en alliage d'argent.

2. Film stratifié transparent selon la revendication 1, dans lequel la couche de film fin contient un film fin en oxyde métallique formé par un procédé sol-gel en utilisant de l'énergie lumineuse au cours du durcissement sol-gel et agencé en contact avec le film polymère transparent.

3. Film stratifié transparent selon la revendication 1 ou 2, dans lequel, lorsque le film fin de post-oxydation contient au moins un d'un film fin formé en post-oxydant le film fin en Ti métallique et d'un film fin formé en post-oxydant le film fin en oxyde de titane partiellement oxydé, le film fin a une épaisseur de film au sein d'une plage de 2 à 6 nm.

4. Film stratifié transparent selon l'une quelconque des revendications 1 à 3, dans lequel l'alliage d'argent contient au moins un type d'élément sélectionné parmi Cu, Cr, Fe, Ni, Pb, Si, Ti, V, Y et Zr comme éléments d'alliage secondaires.

5. Film stratifié transparent selon l'une quelconque des revendications 1 à 4, dans lequel l'alliage d'argent est un d'un alliage de Ag-Cu et d'un alliage de Ag-Ti.

6. Film stratifié transparent selon l'une quelconque des revendications 1 à 5, dans lequel le film est destiné à la découpe au rayon thermique.

7. Film stratifié transparent selon l'une quelconque des revendications 1 à 6, dans lequel le film fin de post-oxydation est stratifié entre le film fin en oxyde métallique formé par un procédé sol-gel et le film fin en oxyde métallique formé par un procédé sol-gel.

8. Procédé de production de film stratifié transparent comprenant :
un processus de stratification formant, sur au moins une surface d'un film polymère transparent, une couche de film fin contenant un film fin en oxyde métallique formé par un procédé sol-gel en utilisant de l'énergie lumineuse au cours du durcissement sol-gel, un film fin en alliage d'argent et au moins un type de film fin sélectionné parmi un film fin en Ti métallique et un film fin en oxyde de titane partiellement oxydé ; et
un processus de post-oxydation formant un film fin de post-oxydation en post-oxydant le film fin en alliage d'argent et l'au moins un type de film fin sélectionné parmi le film fin en Ti métallique et le film fin en oxyde de titane partiellement oxydé, le film fin de post-oxydation étant contenu dans la couche de film fin.

9. Procédé de production de film stratifié transparent selon la revendication 8, dans lequel le processus de post-oxydation est réalisé en post-oxydant le film polymère transparent ayant la couche de film fin.

10. Procédé de production de film stratifié transparent selon la revendication 9, dans lequel le film polymère transparent ayant la couche de film fin est enroulé en une forme de type rouleau.

11. Procédé de production de film stratifié transparent selon l'une quelconque des revendications 8 à 10, dans lequel la post-oxydation est réalisée par le biais d'un traitement thermique.

12. Procédé de production de film stratifié transparent selon la revendication 11, dans lequel une température de chauffage au cours du traitement thermique est inférieure ou égale à une température de ramollissement d'un matériau constituant le film polymère transparent ayant la couche de film fin.
